# FASCICULE DE BREVET EUROPEEN

(11) **EP 3 291 293 B1**
(45) Date de publication et mention de la délivrance du brevet: **03.07.2019**
(21) Numéro de dépôt: 17172303.4
(22) Date de dépôt: 22.05.2017
(51) Int. Cl.: H01L 23/00, H01L 23/58, H01L 23/64, H01L 23/498, H01L 23/48, H01L 21/768, H01L 23/29, H01L 23/31, H03K 3/3565

(54) **PUCE PROTÉGÉE CONTRE LES ATTAQUES FACE ARRIÈRE**
CHIP, DER GEGEN ANGRIFFE AUF DIE RÜCKSEITE GESCHÜTZT IST
CHIP PROTECTED AGAINST BACKEND ATTACKS

(30) Priorité: 31.08.2016 FR 1658070
(43) Date de publication de la demande: 07.03.2018
(73) Titulaire: STMicroelectronics (Crolles 2) SAS, 38920 Crolles (FR)
(72) Inventeur: PETITDIDIER, Sébastien, 38660 LA TERRASSE (FR); HOTELLIER, Nicolas, 38560 JARRIE (FR); BIANCHI, Raul Andres, 73800 MYANS (FR); FARCY, Alexis, 73490 LA RAVOIRE (FR); FROMENT, Benoît, 38000 GRENOBLE (FR)
(74) Mandataire: Cabinet Beaumont

(56) Documents cités:
- EP-A1- 2 866 259
- EP-A2- 3 046 147
- US-A1- 2010 187 525

## Description

### Domaine

La présente demande concerne les puces électroniques, plus particulièrement des puces électroniques protégées contre des attaques effectuées depuis la face arrière.

### Exposé de l'art antérieur

Des puces électroniques contenant des informations confidentielles, telles que des puces de cartes bancaires, sont susceptibles de subir des attaques de pirates visant à déterminer le fonctionnement de la puce et à en extraire les informations confidentielles.

On considère ici le cas où, pour réaliser une attaque, un pirate creuse une cavité à partir de la face arrière de la puce, par exemple par un faisceau d'ions, en ayant éventuellement aminci le substrat précédemment. Le pirate peut alors installer dans la cavité des contacts avec les composants situés en face avant, et analyser le fonctionnement de la puce.

Il serait souhaitable d'avoir une puce pouvant résister à ces types d'attaque.

EP 2 866 259 A1, US 2010/187525 A1 et EP 3 046 147 A2 divulguent des puces électroniques munies de dispositifs pour protection contre des attaques physiques.

### Résumé

Ainsi, un mode de réalisation prévoit une puce semiconductrice comprenant au moins deux vias isolés traversant la puce de la face avant à la face arrière dans laquelle, du côté de la face arrière, les vias sont connectés à une même bande conductrice et, du côté de la face avant, chaque via est séparé d'un plot conducteur par une couche d'un diélectrique.

Selon un mode de réalisation, la puce comprend une pluralité d'éléments tels que ci-dessus dont les bandes conductrices sont parallèles les unes aux autres.

Selon un mode de réalisation, la bande conductrice forme un serpentin sur au moins une portion de la surface de la face arrière.

Selon un mode de réalisation, la puce comprend des plots conducteurs leurres ou des vias leurres.

Selon un mode de réalisation, la face arrière de la puce est uniformément recouverte d'un matériau isolant.

Selon un mode de réalisation, la couche de diélectrique est de l'oxyde de silicium.

Selon un mode de réalisation, la bande conductrice est en cuivre, en titane ou en aluminium.

Selon un mode de réalisation, le matériau isolant recouvrant la face arrière est un polymère ou de l'oxyde de silicium.

Un mode de réalisation prévoit un procédé de fabrication d'une puce semiconductrice comprenant les étapes suivantes :
formation de plots conducteurs sur la face avant d'un substrat ;
amincissement de la face arrière ;
gravure d'ouvertures sous les plots conducteurs depuis la face arrière avec arrêt lorsque le plot conducteur est atteint ;
dépôt d'une couche d'un diélectrique sur les parois et le fond des ouvertures ; et
formation d'une couche conductrice dans les ouvertures et d'une bande conductrice reliant les couches conductrices entre elles.

Selon un mode de réalisation, chaque plot conducteur est une région dopée de type N.

Selon un mode de réalisation, les régions dopées de type N ont une hauteur comprise entre 1 µm et 10 µm.

L'invention est définie par la puce semiconductrice de la revendication 1 et par le procédé de fabrication de la revendication 9.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue de dessus d'un mode de réalisation d'une puce protégée des attaques face arrière ;
la figure 1B est une vue en coupe selon la ligne B-B de la figure 1A ;
la figure 1C est un schéma électrique équivalent ;
la figure 2 représente le schéma électrique d'un exemple de capacimètre ;
la figure 3 est une vue de dessus d'un mode de réalisation d'une puce protégée des attaques face arrière ;
la figure 4 est une vue de dessus d'un autre mode de réalisation d'une puce protégée des attaques face arrière ;
la figure 5 est une vue en coupe d'un autre mode de réalisation d'une puce protégée des attaques face arrière ;
la figure 6 est une vue en coupe d'un autre mode de réalisation d'une puce protégée des attaques face arrière ;
la figure 7 est une vue en coupe d'un autre mode de réalisation d'une puce protégée des attaques face arrière ;
les figures 8A à 8D sont des vues en coupe illustrant des étapes successives d'un procédé de fabrication d'une puce protégée des attaques face arrière ; et
les figures 9A et 9B sont des vues en coupe illustrant des étapes successives d'un autre procédé de fabrication d'une puce protégée des attaques face arrière.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "avant", "arrière", etc., ou relative, tels que les termes "supérieur", etc., il est fait référence à l'orientation des figures dans une position normale d'utilisation. Dans les vues de dessus, les éléments figurés en pointillés sont vus par transparence de la puce considérée.

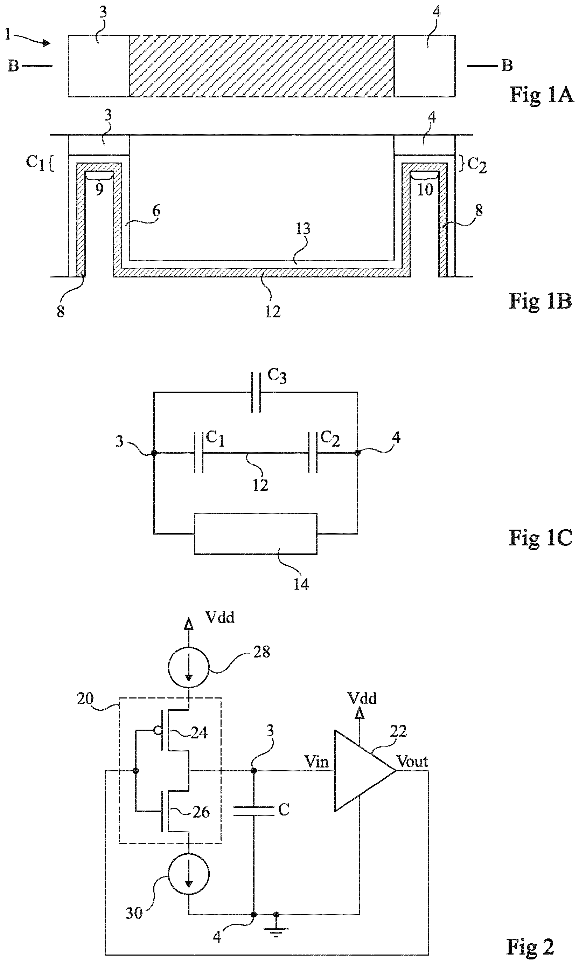

La figure 1A est une vue de dessus d'un mode de réalisation d'une puce semiconductrice 1 protégée des attaques face arrière. La figure 1B est une vue en coupe selon le plan B-B de la figure 1A. Deux plots conducteurs 3 et 4 sont formés sur la face avant de la puce 1. En regard de chacun de ces plots conducteurs, des ouvertures ont été formées à partir de la face arrière de la puce. Ces ouvertures ont ensuite été gainées d'une couche d'un diélectrique 6 recouverte d'une couche conductrice 8. Ainsi, les parties supérieures 9 et 10 de la couche conductrice 8 sont respectivement en regard des plots conducteurs 3 et 4. Il existe ainsi un condensateur C1 entre le plot 3 et la partie supérieure 9 de la couche conductrice 8 et un condensateur C2 entre le plot 4 et la partie supérieur 10 de la couche conductrice 8. Une bande conductrice 12 s'étend sur la face arrière et connecte les couches conductrices 8 formées en regard des plots conducteurs 3 et 4. Dans le cas où le substrat de la puce est en un matériau conducteur, la bande conductrice 12 est séparée du substrat par une couche d'isolant 13.

Comme l'illustre la figure 1C, il existe, entre les plots 3 et 4, deux condensateurs C1 et C2 connectés en série par la bande 12. On a également figuré un condensateur C3 correspondant à diverses capacités parasites incluant la capacité de couplage direct entre les plots conducteurs 3 et 4. La capacité du condensateur C3 est normalement très inférieure à la valeur de la capacité des condensateurs C1 et C2 en série. Un capacimètre 14 mesure la valeur normale de l'ensemble des capacités C1, C2 et C3. Si la connexion constituée par la bande 12 entre les capacités C1 et C2 est coupée, la valeur de la capacité mesurée par le capacimètre chute brutalement. Ce dispositif permet donc de détecter toute atteinte à l'intégrité de la bande conductrice 12.

De façon classique, un pirate tentera pour réaliser une analyse des composants situés entre les plots 3 et 4 d'amincir la puce à partir de la face arrière. Il détruira alors la bande conductrice 12 et cela sera détecté. De même si le pirate effectue un perçage qui affecte la bande 12, ceci sera également détecté.

La figure 2 représente le schéma électrique d'un exemple de capacimètre mesurant la capacité C entre les bornes 3 et 4 d'un condensateur. La borne 4 est reliée à la terre et la borne 3 est reliée à un noeud entre la sortie d'un inverseur 20 et l'entrée d'une bascule de Schmitt 22 ayant des seuils haut et bas, Vhigh et Vlow. La sortie de la bascule 22 est connectée à l'entrée de l'inverseur 20. La tension de sortie de la bascule 22, Vout, peut prendre deux valeurs, 0 et Vdd, fournies à la bascule 22 par la terre et une source de tension continue fixe Vdd. L'inverseur 20 comprend deux transistors MOS 24 et 26, respectivement à canal P et à canal N. Le transistor 24 relie, via ses noeuds de conduction, la sortie d'une source 28 de courant I et le noeud 3. Le transistor 26 relie, via ses noeuds de conduction, le noeud 3 et l'entrée d'une source 30 de courant I. De plus, l'entrée de la source 28 est reliée à la source de tension continue Vdd et la sortie de la source 30 est reliée à la terre.

Lorsque la tension Vin à l'entrée de la bascule 22 et donc aux bornes du condensateur atteint la valeur Vlow, la bascule 22 passe dans un état tel que sa sortie Vout prend la valeur 0. L'inverseur 20 passe alors dans un état tel que le transistor 24 devient passant, et le condensateur se charge jusqu'à ce que Vin atteigne la valeur Vhigh, déclenchant le changement d'état de la bascule 22 dont la sortie passe à Vdd. L'inverseur 20 passe alors dans un état tel que le transistor 26 devient passant, et le condensateur se décharge jusqu'à ce que Vin atteigne la valeur Vlow, déclenchant le changement d'état de la bascule 22 dont la sortie passe à 0.

La mesure de la capacité C se fait par l'intermédiaire de la mesure de la période T du signal de sortie de la bascule 22. La période T correspond à une charge et une décharge à courant fixe I du condensateur C sur une plage de tension [Vlow, Vhigh]. La valeur de la capacité C est donc la moitié de la période T multipliée par la valeur I du courant et divisée par la différence de tension ΔV = Vhigh - Vlow.

Le dispositif de protection tel que présenté en relation avec les figures 1A et 1B n'est en fait efficace que pour détecter un amincissement de la puce ou un perçage ciblant précisément des composants placés entre les deux plots conducteurs 3 et 4.

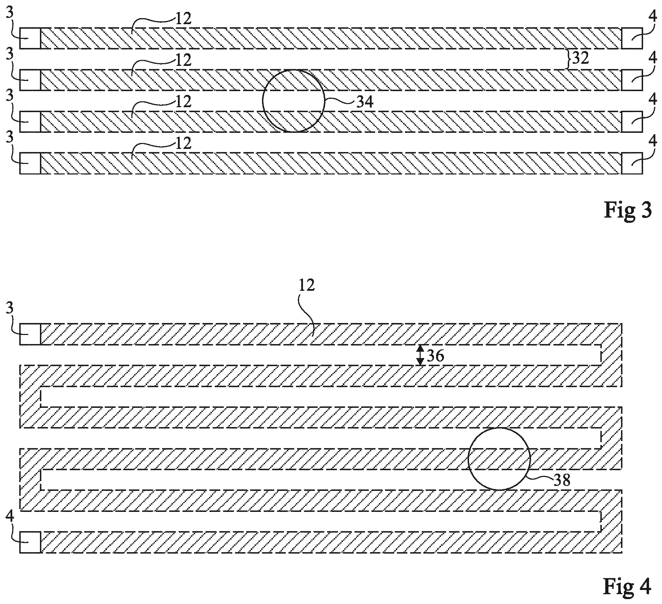

Dans la structure de la figure 3, on a répété parallèlement les unes aux autres des structures telles que celle des figures 1A et 1B. Ainsi, la figure 3 représente plusieurs bandes conductrices 12 s'étendant sur la face arrière du substrat entre des vias disposés en regard de plots 3 et 4.

La largeur des bandes 12 et la distance 32 séparant les bandes 12 sont déterminées en prenant en compte la taille minimale de percée possible avec les technologies existantes, de telle manière qu'un perçage 34, quel que soit son emplacement, coupe au moins une connexion entre deux plots conducteurs. Actuellement la taille d'une percée est par exemple de 3 x 3 µm².

Le mode de réalisation de la figure 3 permet de couvrir et donc de protéger une surface plus grande que le mode de réalisation des figures 1A et 1B. De plus, la surveillance de la capacité entre chaque couple de plots 3 et 4 permet de déterminer l'emplacement de l'attaque avec une précision qui dépend de la densité de plots.

La figure 4 est une vue de dessus d'un autre mode de réalisation d'une puce protégée des attaques face arrière. On a construit sur la puce une structure telle que décrite dans les figures 1A et 1B, où la bande conductrice 12 est prolongée en forme de serpentin sous la surface à protéger. Les dimensions du serpentin, la largeur de la bande métallique 12, ainsi que la distance 36 entre deux parties voisines de la bande conductrice 12 sont déterminées en prenant en compte la taille minimale de percée possible avec les technologies existantes, de telle manière qu'un perçage 38, quel que soit son emplacement, coupe la connexion entre les plots conducteurs. Cette configuration permet de détecter, par une seule mesure de capacité, une tentative de perçage sur l'ensemble de la surface à protéger.

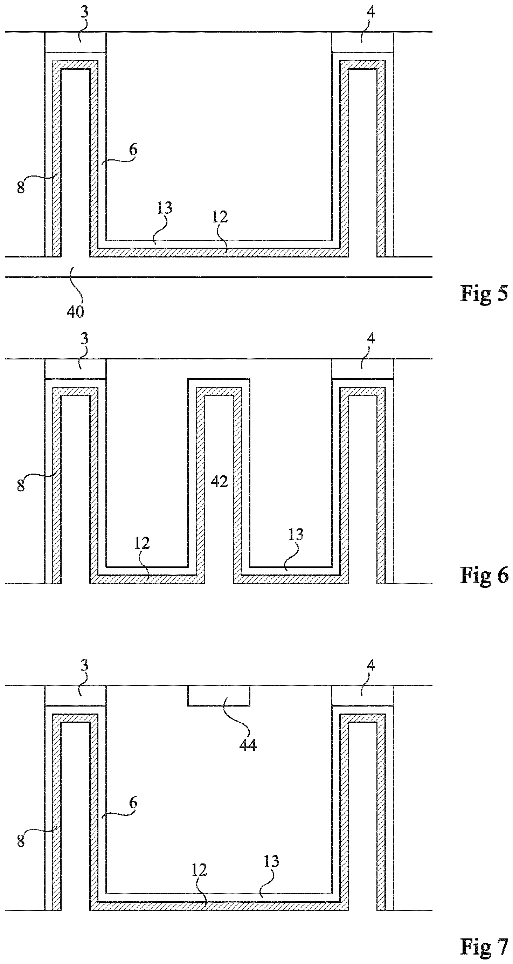

La figure 5 est une vue en coupe d'un autre mode de réalisation d'une puce protégée des attaques face arrière. La face arrière d'une structure telle que celle de la figure 1B est recouverte uniformément d'un matériau isolant 40 qui remplit les ouvertures en regard des plots conducteurs 3 et 4. Ce remplissage sert par exemple à rigidifier la structure mécaniquement, à améliorer l'opacité ou à perturber les attaques chimiques ou par polissage face arrière. De plus la présence du matériau 40 sur la face arrière masque la présence des bandes conductrices 12. A titre d'exemple, le matériau de remplissage peut être un polymère ou un oxyde de silicium.

Un pirate cherchant à analyser les composants d'une puce semiconductrice et connaissant l'existence et la nature d'un système de protection pourra utiliser cette information pour chercher à violer le système de protection. On propose ici de rendre la connaissance du système de protection plus difficile en y incorporant des leurres.

La figure 6 illustre un premier type de leurre. Une ouverture 42 sur la face arrière est formée de la même façon que les ouvertures creusées sous les plots 3 et 4, mais n'est pas située en regard d'un plot conducteur. Elle est, de plus, connectée à la bande 12 de telle manière qu'elle fait partie de la connexion entre les deux électrodes 3 et 4.

La figure 7 illustre un second type de leurre. Un plot conducteur 44 est disposé sur la face avant mais n'est pas en regard d'un via relié à une bande conductrice sur la face arrière. Le plot 44 est placé parmi les composants du circuit. Une analyse de ce composant en face avant ne donnera aucune information sur le dispositif de protection.

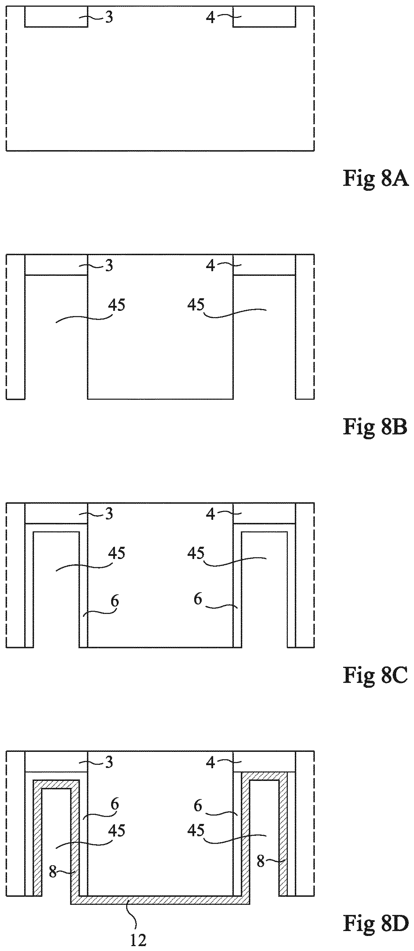

Le dispositif de protection de la puce tel que décrit en relation avec les figures 1A et 1B peut être fabriqué de diverses façons. Les figures 8A à 8D illustrent des étapes successives d'un procédé de fabrication de ce dispositif.

La figure 8A illustre la formation de plots conducteurs 3 et 4 sur la face avant d'une puce semiconductrice. Les plots sont par exemple formés par implantation de dopant à haute dose. Après cela, la plaquette est amincie à partir de sa face arrière par exemple jusqu'à une épaisseur de 100 à 200 µm, par exemple 140 µm.

La figure 8B illustre la gravure d'une ouverture 45 sous chaque plot conducteur 3 ou 4 depuis la face arrière avec arrêt lorsque le plot conducteur est atteint.

La figure 8C illustre le dépôt d'une couche d'un diélectrique 6 sur les parois et le fond des ouvertures 45. Dans ce mode de réalisation, le diélectrique 6 situé hors des ouvertures 45 a été retiré.

La figure 8D illustre le dépôt d'une couche conductrice 8 dans les ouvertures 45. Cette couche est maintenue sur la face arrière en une bande conductrice 12 qui relie les couches conductrices 8 entre elles.

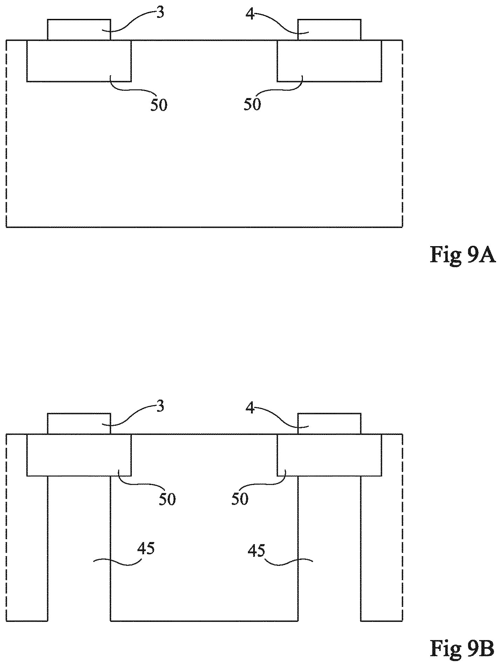

Les figures 9A et 9B illustrent des étapes d'un autre procédé de fabrication.

La figure 9A illustre des caissons isolants STI (de l'anglais "Shallow Trench Isolation" ou isolement par tranchées peu profondes) 50 formés sur la face avant. Des plots conducteurs 3 et 4 sont formés sur les caissons 50. Les plots 3 et 4 sont, par exemple, des plots de polysilicium formés en même temps que les grilles de transistors MOS, ou des plots de tungstène, formés en même temps que les contacts électriques de transistors MOS.

L'étape suivante, illustrée par la figure 9B, correspond à l'étape précédemment décrite en relation avec la figure 8B : la formation d'ouvertures 45 en regard des plots conducteurs, mais cette fois-ci avec arrêt quand les ouvertures atteignent les caissons STI 50. A titre de variante, la formation des ouvertures 45 peut comprendre une étape de gravure d'une partie de l'épaisseur du matériau diélectrique formant les caissons STI 50.

Les dernières étapes, le dépôt d'une couche de diélectrique et le dépôt d'une couche conductrice, sont similaires aux étapes du procédé décrit en relation avec les figures 8C et 8D.

A titre d'exemple, le diélectrique 6 peut être de l'oxyde de silicium et le conducteur 8 du cuivre, du titane ou de l'aluminium.

On comprendra que les deux procédés décrits ici sont susceptibles de nombreuses variantes. D'autres procédés pourront être utilisés pour atteindre le résultat souhaité.

Des modes de réalisation particuliers ont été décrits. Diverses variantes et modifications apparaîtront à l'homme de l'art. En particulier, le nombre de plots conducteurs 3 et 4 et la forme des bandes conductrices 12 les reliant les uns aux autres peuvent varier dans la mesure où tout perçage en face arrière coupe au moins une connexion entre deux plots conducteurs reliés entre eux par un capacimètre. La bande conductrice, au lieu d'avoir une forme en serpentin, pourra prendre la forme d'une spirale, ou plus généralement celle de n'importe qu'elle courbe remplissante, comme par exemple une courbe de Peano ou une courbe de Koch, s'étendant sur une portion de surface à protéger de la face arrière de la puce, de telle manière qu'un perçage, quel que soit son emplacement sur la surface à protéger, coupe la bande conductrice. Des structures en peignes peuvent également être utilisées.

## Revendications

1. Puce semiconductrice comprenant un élément avec au moins deux vias isolés (8) traversant la puce de la face avant à la face arrière dans lequel du côté de la face arrière de la puce, les vias sont connectés à une même bande conductrice (12) et, du côté de la face avant de la puce, chaque via est séparé d'un plot conducteur (3, 4) respectif par une couche d'un diélectrique (6).

2. Puce semiconductrice selon la revendication 1, comprenant au moins un élément additionnel, les bandes conductrices (12) des éléments étant parallèles les unes aux autres.

3. Puce semiconductrice selon la revendication 1, dans laquelle la bande conductrice (12) forme un serpentin sur au moins une portion de la surface de la face arrière.

4. Puce semiconductrice selon l'une quelconque des revendications 1 à 3, comprenant des plots conducteurs leurres (44) ou des vias leurres (42).

5. Puce semiconductrice selon l'une quelconque des revendications 1 à 4, dans laquelle la face arrière de la puce est uniformément recouverte d'un matériau isolant (40).

6. Puce semiconductrice selon la revendication 5, dans laquelle le matériau isolant (40) recouvrant la face arrière est un polymère ou de l'oxyde de silicium.

7. Puce semiconductrice selon l'une quelconque des revendications 1 à 6, dans laquelle la couche de diélectrique (6) est de l'oxyde de silicium.

8. Puce semiconductrice selon l'une quelconque des revendications 1 à 7, dans laquelle la bande conductrice (12) est en cuivre, en titane ou en aluminium.

9. Procédé de fabrication configuré pour délivrer la puce de la revendication 1 comprenant les étapes suivantes :
formation de plots conducteurs (3, 4) sur la face avant d'un substrat ;
amincissement de la face arrière ;
gravure d'ouvertures sous les plots conducteurs (3, 4) depuis la face arrière avec arrêt lorsque le plot conducteur est atteint ;
dépôt d'une couche d'un diélectrique (6) sur les parois et le fond des ouvertures ; et
formation d'une couche conductrice (8) dans les ouvertures et d'une bande conductrice (12) reliant les couches conductrices (8) entre elles.

10. Procédé de fabrication d'une puce semiconductrice selon la revendication 9, dans lequel chaque plot conducteur (3, 4) est une région dopée de type N.

11. Procédé de fabrication d'une puce semiconductrice selon la revendication 10, dans lequel les régions dopées de type N ont une hauteur comprise entre 1 µm et 10 µm.

## Patentansprüche

1. Halbleiterchip mit einem Element mit wenigstens zwei isolierten Durchkontaktierungen (8), die durch den Chip von der Vorderseite zur Rückseite verlaufen, wobei die Durchkontaktierungen auf der Seite der Rückseite des Chips mit ein und demselben leitenden Streifen (12) verbunden sind und auf der Seite der Vorderseite des Chips jede Durchkontaktierung durch eine Schicht aus einem Dielektrikum (6) von einem jeweiligen Leiterpad (3, 4) getrennt ist.

2. Halbleiterchip nach Anspruch 1, der wenigstens ein zusätzliches Element aufweist, wobei die leitenden Streifen (12) der Elemente parallel zueinander sind.

3. Halbleiterchip nach Anspruch 1, bei dem der leitende Streifen (12) auf wenigstens einem Teil der Oberfläche der Rückseite eine Serpentine bildet.

4. Halbleiterchip nach einem der Ansprüche 1 bis 3, der Täusch-Leiterpads (44) oder Täusch-Durchkontaktierungen (42) aufweist.

5. Halbleiterchip nach einem der Ansprüche 1 bis 4, bei dem die Rückseite des Chips gleichmäßig mit einem Isoliermaterial (40) abgedeckt ist.

6. Halbleiterchip nach Anspruch 5, bei dem das die Rückseite abdeckende Isoliermaterial (40) ein Polymer oder Siliziumoxid ist.

7. Halbleiterchip nach einem der Ansprüche 1 bis 6, bei dem die dielektrische Schicht (6) Siliziumoxid ist.

8. Halbleiterchip nach einem der Ansprüche 1 bis 7, bei dem der leitende Streifen (12) aus Kupfer, Titan oder Aluminium hergestellt ist.

9. Verfahren zur Herstellung, das konfiguriert ist, um den Chip nach Anspruch 1 vorzusehen, das die folgenden Schritte aufweist:
Ausbilden von leitenden Pads (3, 4) auf der Vorderseite eines Substrats;
Dünnermachen der Rückseite;
Ätzen von Öffnungen unter den leitenden Pads (3, 4) von der Rückseite aus, und stoppen, wenn die leitenden Pads erreicht werden;
Abscheiden einer Schicht eines Dielektrikums (6) an den Wänden und dem Boden der Öffnungen; und
Ausbilden einer leitenden Schicht (8) in den Öffnungen und eines leitenden Streifens (12), das die leitenden Schichten (8) miteinander verbindet.

10. Verfahren zur Herstellung eines Halbleiterchips nach Anspruch 9, bei dem jedes leitende Pad (3, 4) ein N-Typ dotierter Bereich ist.

11. Verfahren zur Herstellung eines Halbleiterchips nach Anspruch 10, bei dem die N-Typ dotierten Bereiche eine Höhe zwischen 1 µm und 10 µm aufweisen.

## Claims

1. Semiconductor chip comprising an element with at least two insulated vias (8) passing through the chip from the front face to the rear face in which, on the side of the rear face of the chip, the vias are connected to one and the same conducting strip (12) and, on the side of the front face of the chip, each via is separated from a respective conducting pad (3, 4) by a layer of a dielectric (6).

2. Semiconductor chip according to Claim 1, comprising at least an additional element, the conducting strips (12) of the elements being parallel to one another.

3. Semiconductor chip according to Claim 1, in which the conducting strip (12) forms a serpentine on at least one portion of the surface of the rear face.

4. Semiconductor chip according to any one of Claims 1 to 3, comprising decoy conducting pads (44) or decoy vias (42).

5. Semiconductor chip according to any one of Claims 1 to 4, in which the rear face of the chip is uniformly covered with an insulating material (40).

6. Semiconductor chip according to Claim 5, in which the insulating material (40) covering the rear face is a polymer or silicon oxide.

7. Semiconductor chip according to any one of Claims 1 to 6, in which the dielectric layer (6) is silicon oxide.

8. Semiconductor chip according to any one of Claims 1 to 7, in which the conducting strip (12) is made of copper, titanium or aluminium.

9. Method for fabricating configured to provide the chip of claim 1, comprising the following steps:
formation of conducting pads (3, 4) on the front face of a substrate;
thinning of the rear face;
etching of openings under the conducting pads (3, 4) from the rear face, stopping when the conducting pad is reached;
deposition of a layer of a dielectric (6) on the walls and the bottom of the openings; and
formation of a conducting layer (8) in the openings and of a conducting strip (12) linking the conducting layers (8) together.

10. Method for fabricating a semiconductor chip according to Claim 9, in which each conducting pad (3, 4) is an N-type doped region.

11. Method for fabricating a semiconductor chip according to Claim 10, in which the N-type doped regions have a height of between 1 µm and 10 µm.
